# DEMANDE DE BREVET EUROPEEN

(11) **EP 2 239 590 A1**
(43) Date de publication de la demande: **13.10.2010**
(21) Numéro de dépôt: 10305313.8
(22) Date de dépôt: 26.03.2010
(51) Int. Cl.: G01R 31/26, G01R 31/28, G01J 5/06, F17C 3/08

(54) **Dispositif pour réaliser la caractérisation des performances électro-optiques d'un composant semi-conducteur**

(30) Priorité: 08.04.2009 FR 0952278
(71) Demandeur: Société Française de Détecteurs Infrarouges - SOFRADIR, 92290 Châtenay Malabry (FR)
(72) Inventeur: Daultier, Yves, 38130 Echirolles (FR); Dupont, Frédéric, 38920 Crolles (FR)
(74) Mandataire: Vuillermoz, Bruno

(57) **Abrégé**

Ce dispositif pour réaliser la caractérisation des performances électro-optiques d'un composant semi-conducteur ou d'un lot de tels composants (10), sous vide ou sous atmosphère contrôlée, comprend :
- une enceinte sous vide ou sous atmosphère contrôlée ;
- une tête de mesure munie de pointes conductrices (6) destinées à venir au contact avec les interfaces électriques dudit composant, et reliées à un système de traitement de données afin de déterminer lesdites performances électro-optiques ;
- une platine support, destinée à recevoir le ou lesdits composants (10), la platine étant susceptible d'être refroidie et d'être animée d'un mouvement de translation ascendant et descendant afin de permettre la mise en contact des interfaces électriques du ou des composants avec l'extrémité des pointes de mesure (6) de la tête de mesure.

La platine est munie de bossages au contact duquel sont positionnés les composants, et reçoit au niveau de chacun de ces bossages deux grilles de positionnement, susceptibles de coulisser l'une par rapport à l'autre et définissant en coopération l'une avec l'autre des logements aptes à recevoir le ou les composants à caractériser.

En outre, la tête de mesure est également munie de pointes mécaniques (18), venant prendre appui sur la zone inactive desdits composants afin d'assurer leur maintien sur la platine.

## Description

### DOMAINE TECHNIQUE

La présente invention se rattache au domaine technique de l'industrie des semi-conducteurs et a notamment vocation à permettre la caractérisation des performances, notamment électro-optiques, d'un composant ou d'un lot de composants unitaires semi-conducteur, particulièrement en simulation de ses (leurs) conditions ultérieures d'utilisation nominale.

### ETAT ANTERIEUR DE LA TECHNIQUE

Dans le domaine de l'électronique en général, et des composants semi-conducteurs de détection infrarouge en particulier, il convient de procéder systématiquement à la vérification de leurs performances avant leur implantation au sein d'une structure plus complexe, notamment de détection. S'agissant des composants mis en oeuvre dans les détecteurs infrarouge, ceux-ci sont classiquement constitués d'hybride unitaires constitués de circuits de détection montés sur un circuit de lecture silicium, leur température nominale de fonctionnement étant classiquement comprise entre 70 et 200 K.

On sait en effet que s'agissant de détecteurs dits « quantiques », la température de fonctionnement imposée par la physique mise en oeuvre est celle de l'azote liquide et que dès lors, il s'avère nécessaire de vérifier les performances effectives des composants à cette température d'utilisation.

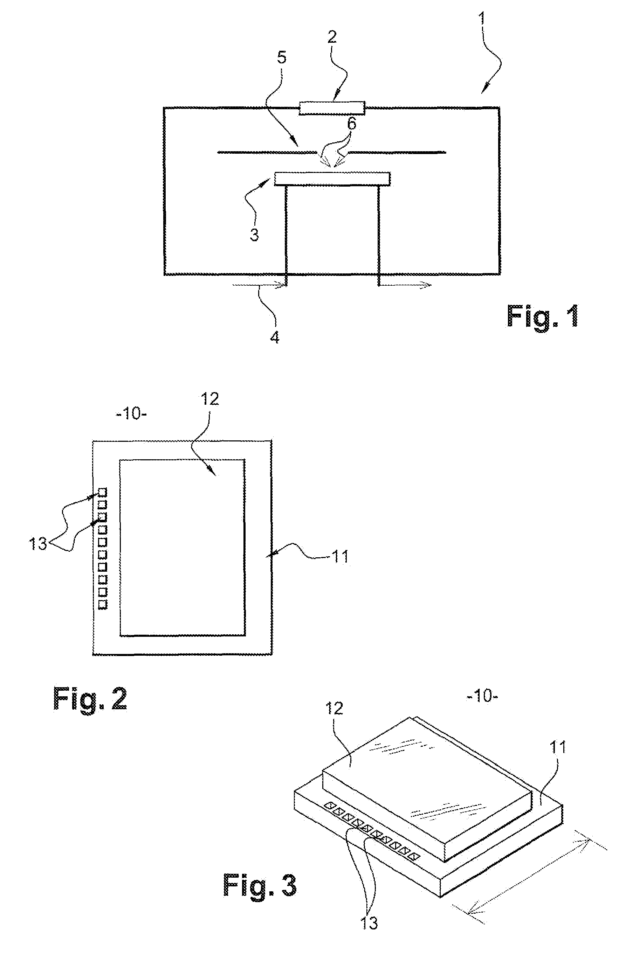

Afin de réaliser de telles caractérisations, il est connu d'utiliser un équipement de test, avantageusement automatisé, couramment dénommé dans le domaine considéré par l'expression « cryoprober ». Un tel équipement, dont le principe général est décrit en relation avec la figure 1, est classiquement composé d'une tête de mesure (5) munie de pointes de mesure (6) venant en contact avec les interfaces électriques du composant semi-conducteur, et d'une platine motorisée (3) asservie à un système de vision et recevant le composant à tester, l'ensemble étant isolé dans une enceinte (1) généralement sous vide secondaire et refroidie à très basse température par circulation d'un fluide cryogénique (4), typiquement de l'azote liquide.

L'enceinte (1) comporte en outre au niveau de sa face supérieure un hublot (2), apte à permettre l'éclairement du composant à tester ou permettant à ce dernier de détecter une scène extérieure à l'enceinte.

Le composant, dont on souhaite réaliser la caractérisation, est déposé et maintenu au contact de la platine (3) au moyen d'un clinquant réalisé en acier oxydable, ladite platine étant motorisée de telle sorte à permettre la venue en contact des interfaces électriques du composant avec l'extrémité des pointes de mesure de la tête de mesure. Celle-ci assure l'activation et la lecture d'information de chacun des composants par une prise de contact séquentielle.

Il résulte de cette structure que les composants à caractériser sont donc refroidis uniquement par conduction thermique au contact de la platine refroidie et au moyen d'un système de maintien mécanique.

En raison des performances attendues dans les applications finales, les composants ne présentent que de très faibles surfaces inactives disponibles pour assurer un tel maintien mécanique, puisqu'aussi bien, l'essentiel de la zone centrale est actif optiquement et la couronne périphérique est principalement réservée à la connectique électrique. On a de fait représenté en relation avec les figures 2 et 3 une représentation schématique d'un tel composant respectivement vu de dessus et en perspective. Ce composant (10) comporte donc une zone centrale active optiquement (12), et une zone périphérique inactive optiquement (11). On a en outre représenté par les références (13) les interfaces électriques du composant.

Ce faisant, seuls les composants présentant des zones inactives suffisamment étendues, et en l'espèce très supérieure au jeu né de la découpe des tranches de silicium, peuvent être testés dans un « cryoprober » à vide secondaire.

Dans l'absolu, on souhaite pouvoir aboutir au résultat suivant :
- permettre le chargement de lots de composants hybrides dans un tel « cryoprober » ;
- disposer d'une compatibilité étendue avec plusieurs géométries de composants ;
- préserver l'intégrité physique et fonctionnelle des composants et notamment ne pas affecter ni la zone active, ni la zone inactive en suite du maintien mécanique ;
- pouvoir assurer le refroidissement nominal des composants sans nécessiter le recours à des colles ou à des graisses ;
- permettre les caractérisations électro-optiques à des températures contrôlées à ± 0,5 K.

Les performances électro-optiques résultant de l'opération de caractérisation sont essentiellement constituées par :
- la sensibilité à l'éclairement ;
- le rapport signal sur bruit ;
- les défauts, c'est-à-dire le nombre de pixels non exploitables de la zone active du composant.

A ce jour, on connaît essentiellement deux types de tels « cryoprober » permettant d'assurer la caractérisation à très basse température.

Tout d'abord, les « cryoprober » dits « à surpression » : dans une telle installation, l'enceinte de test est placée en surpression par balayage de gaz non condensable à la température de caractérisation, ledit gaz étant généralement constitué par de l'azote sec.

Les composants à caractériser sont maintenus par dépression en face arrière au niveau de la platine. Le transfert thermique est assuré par la couche de gaz résiduelle entre le composant et la platine, ainsi que par convection de gaz froid entre la platine et la tête de mesure refroidie.

Si avec de tels « cryoprobers » dits « à surpression », on dispose d'une efficacité élevée de refroidissement des composants, et en outre, on assure un maintien des composants sans contact mécanique face avant, donc préservant leur intégrité physique, en revanche on se heurte à un problème de consommation élevé de fluide cryogénique. En outre, le refroidissement par convection constitue une limitation pour certaines caractérisations électro-optiques, et notamment les mesures de bruit, polluées par les variations des paramètres sensibles aux fluctuations thermiques.

On connaît également les « cryoprobers » dits « a vide secondaire ». Dans ce cadre, l'enceinte de test est placée sous vide secondaire. Les composants sont maintenus sur la platine refroidie à l'aide d'une grille équipée d'un clinquant réalisé en acier inoxydable. Le contact thermique entre les composants et la platine refroidie est assuré par la force mécanique de pression appliquée en face avant par le clinquant, cette force s'exerçant au niveau des zones inactives des circuits.

Ces « cryoprobers» a vide secondaire présentent l'avantage de pouvoir disposer de conditions de caractérisation nominale équivalentes à l'application finale envisagée en raison de l'absence de convection interne, outre d'induire une faible consommation de fluide cryogénique.

En revanche, on se heurte à des contraintes de design nécessaires pour garantir le maintien mécanique et le contact thermique du composant au niveau de la platine, en général incompatibles avec la miniaturisation des composants, objectif sans cesse présent pour l'homme du métier.

L'invention a justement pour objet une optimisation du maintien des composants hybrides sur la platine refroidie sans affecter l'intégrité physique dudit composant et sans impacter sur l'efficacité du refroidissement proprement dit.

### EXPOSE DE L'INVENTION

A cet effet, l'invention vise un dispositif pour réaliser la caractérisation des performances électro-optiques d'un composant semi-conducteur ou d'un lot de tels composants, sous vide ou sous atmosphère contrôlée, comprenant :
- une enceinte sous vide ou sous atmosphère contrôlée ;
- une tête de mesure munie de pointes conductrices destinées à venir au contact avec les interfaces électriques dudit composant, et reliées à un système de traitement de données afin de déterminer lesdites performances électro-optiques ;
- une platine support, destinée à recevoir le ou lesdits composants, la platine étant susceptible d'être refroidie et d'être animée d'un mouvement de translation ascendant et descendant afin de permettre la mise en contact des interfaces électriques du ou des composants avec l'extrémité des pointes de mesure de la tête de mesure ;

Selon l'invention :
- la platine est munie de bossages au contact duquel sont positionnés les composants ;
- la platine reçoit au niveau de chacun de ces bossages deux grilles de positionnement susceptibles de coulisser l'une par rapport à l'autre et définissant en coopération l'une avec l'autre des logements aptes à recevoir le ou les composants à caractériser ;
- la tête de mesure est également munie de pointes mécaniques, venant prendre appui sur la zone inactive desdits composants afin d'assurer leur maintien sur la platine.

En d'autres termes, le maintien des composants dont on souhaite mesurer les performances électro-optiques n'est plus assuré par un outil associé à la platine support mais directement par la tête de mesure. En raison de la finesse des pointes mécaniques associées à la tête de mesure, il n'y a plus de risques d'affecter l'intégrité physique des composants.

Selon une caractéristique avantageuse de l'invention, chacun des bossages de la platine reçoit une interface en indium, propre à favoriser le transfert thermique entre la platine et le composant.

Avantageusement, l'interface en indium présente une épaisseur typique comprise entre 20 et 200 micromètres et est rapportée par collage sur les bossages ménagés au sein de la platine.

Selon une autre caractéristique avantageuse de l'invention, les grilles coulissantes de positionnement sont munies au niveau des tranches de leurs parois latérales en regard, de micro dentures interdisant un déplacement intempestif dudit composant après mise en place.

Selon une autre caractéristique de l'invention, il peut être adjoint à la tête de mesure des pointes surnuméraires afin d'optimiser le maintien mécanique du composant sur la platine et/ou des pointes spécifiques du type plot à piston de dimensions plus importantes.

### BREVE DESCRIPTION DES FIGURES

La manière dont l'invention peut être réalisée et les avantages qui en découlent ressortiront mieux de l'exemple de réalisation qui suit, donné à titre indicatif et non limitatif à l'appui des figures annexées.
La figure 1 est, comme déjà dit, une réalisation schématique du principe de fonctionnement d'un « cryoprober ».
Les figures 2 et 3, également déjà décrites, sont des représentations schématiques d'un composant de facture classique, respectivement en vue de dessus et vue en perspective.
La figure 4 est une représentation schématique d'une vue de dessus de la platine refroidie mise en oeuvre dans le dispositif conforme à l'invention.
La figure 5 illustre la coopération des grilles de positionnement mise en oeuvre au niveau de la platine.
La figure 6 est une vue de détail de l'une des deux grilles de positionnement conforme à l'invention.
La figure 7 est une représentation schématique vue de dessus de la tête de mesure conforme à l'invention, dont la figure 8 est une réalisation schématique en perspective.
La figure 9 est une variante de réalisation de l'invention tendant à illustrer la mise en oeuvre de plots de maintien.

### DESCRIPTION DETAILLEE DE L'INVENTION

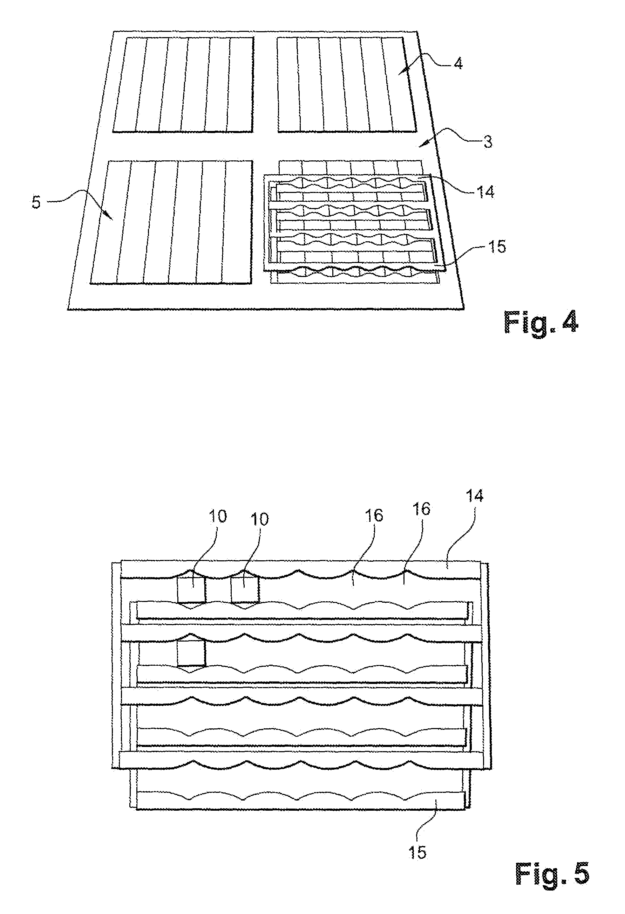

On a donc représenté en relation avec la figure 4 la face supérieure de la platine (3) conforme à l'invention.

Cette platine (3) est typiquement réalisée en cuivre ou en aluminium. Elle est en l'espèce divisée en quatre zones identiques propres à favoriser le chargement de petites séries de composants dont on souhaite réaliser la caractérisation. Chaque zone est définie en fait par un bossage de quelques millimètres, usiné dans la masse, de planéité typique de l'ordre de 5 µm/cm.

On rapporte sur ces bossages, notamment par collage, une interface en indium (4) d'épaisseur comprise entre 20 et 200 micromètres.

Sous ladite platine, circule un fluide cryogénique, en l'espèce de l'azote liquide (non représenté).

L'interface d'indium présente des rainures en colonnes (5), permettant l'introduction à ce niveau de pinces de manipulation des composants, et donc favorisant leur préhension ou leur positionnement sur la platine, sans risquer de les détériorer.

En outre, chacune des zones (4) de la platine reçoit un jeu de deux grilles de positionnement (14) et (15), coulissant l'une par rapport à l'autre. Ces deux grilles sont destinées à coopérer entre elles afin de définir des logements (16) au niveau desquels sont positionnés les composants (10).

Ces grilles sont typiquement réalisées en aluminium ou en acier inoxydable et présentent au niveau de leur tranche latérale en regard des micro-dentures (17) favorisant le maintien des composants à ce niveau.

On peut ainsi observer sur la figure 5 la possibilité de positionner une pluralité de composants sur une même zone (4) de la platine.

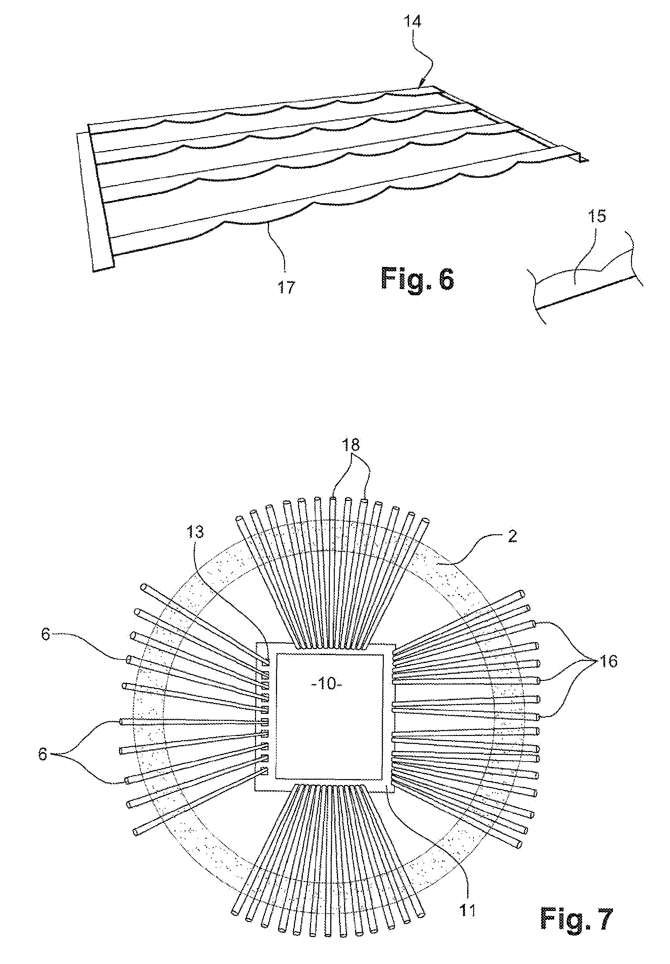

En figure 7, on a représenté en vue de dessus le principe de maintien des composants (10) sur ladite platine conformément à l'invention, les grilles de positionnement (14, 15) n'ayant pas été représentées aux fins de ne pas surcharger inutilement la figure.

En l'espèce, la tête de mesure comporte quatre jeux de pointes, respectivement un jeu de pointes de mesure proprement dite (6), dont l'extrémité libre vient prendre contact avec les interfaces électriques (13) du composant (10), et trois jeux de pointes assurant une seule fonction de maintien (18), venant prendre appui au niveau de la zone inactive périphérique (11) dudit composant.

Ces pointes sont classiquement réalisées à base d'alliage tungstène rhénium, présentent une longueur libre voisine de 5 millimètres, avec un profil conique typiquement de diamètre de 200 micromètres à la racine, c'est-à-dire au niveau de leur zone de fixation à la tête de mesure proprement dite, et de 40 micromètres au niveau de la zone de contact avec le composant (10). La contrainte mécanique exercée par chacune des pointes est voisine de 1g pour 20 micromètres de contact.

Avantageusement, les pointes de mesure et de maintien sont de nature identique.

On conçoit dès lors que lorsque la platine (3) subit un mouvement ascendant, les pointes, qu'il s'agisse des pointes de mesure électrique (6) ou les pointes mécaniques de maintien (18) viennent pendre appui au niveau des zones précédemment décrites du composant, les pointes mécaniques assurant le maintien du composant sur ladite platine.

Ce faisant, en raison du diamètre réduit de l'extrémité libre des pointes ou extrémités de contact, il n'y a pas de risque d'affecter l'intégrité physique du composant puisqu'aussi bien, ces pointes n'interagissent qu'avec les zones inactives du composant ou viennent en contact limitativement au niveau des interfaces électriques.

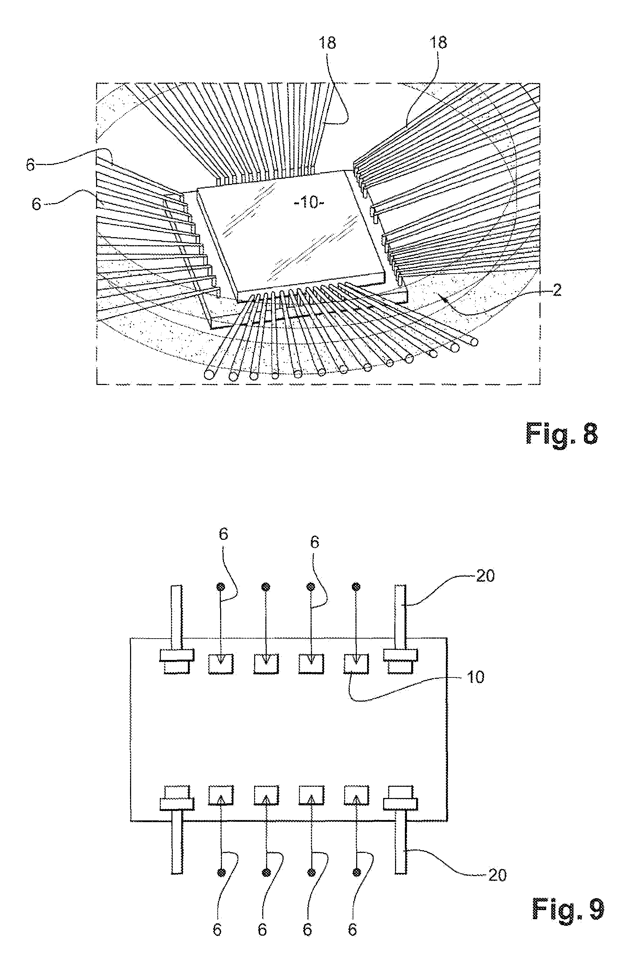

Ceci apparaît également très clairement au niveau de la figure 8.

En outre, en raison de la présence au sein des testeurs ou « cryoprobers » de système optique d'auto-alignement, on dispose systématiquement d'un centrage précis du composant à tester avec la tête de mesure, de sorte que là encore, tout risque de détérioration du composant est évité.

On a représenté en relation avec la figure 9 une variante de l'invention, dans laquelle le maintien du composant sur la platine est assuré par des pointes de test spécifiques en l'espèce constituées de plots à piston (20). Ceux-ci coopèrent avec une zone spécifique, dédiée à cet effet, ménagée au niveau de la zone inactive du composant.

On conçoit de fait tout l'intérêt de la présente invention qui, par un dispositif simple à réaliser et à mettre en oeuvre, favorise le maintien du composant dont on souhaite mesurer les performances électro-optiques au niveau de la platine de refroidissement, sans affecter son intégrité physique. En outre, en raison de l'optimisation du maintien mécanique, on améliore également le contact thermique du composant avec ladite platine.

## Revendications

1. Dispositif pour réaliser la caractérisation des performances électro-optiques d'un composant semi-conducteur ou d'un lot de tels composants (10), sous vide ou sous atmosphère contrôlée, comprenant :
- une enceinte (1) sous vide ou sous atmosphère contrôlée ;
- une tête de mesure (5) munie de pointes conductrices (6) destinées à venir au contact avec les interfaces électriques (13) dudit composant, et reliées à un système de traitement de données afin de déterminer lesdites performances électro-optiques ;
- une platine support (3), destinée à recevoir le ou lesdits composants (10), la platine étant susceptible d'être refroidie et d'être animée d'un mouvement de translation ascendant et descendant afin de permettre la mise en contact des interfaces électriques (13) du ou des composants avec l'extrémité des pointes de mesure (6) de la tête de mesure ;
***caractérisé :***
- **en ce que** la platine (3) est munie de bossages au contact duquel sont positionnés les composants ;
- **en ce que** la platine (3) reçoit au niveau de chacun de ces bossages deux grilles de positionnement (14, 15), susceptibles de coulisser l'une par rapport à l'autre et définissant en coopération l'une avec l'autre des logements (16) aptes à recevoir le ou les composants à caractériser ;
- et, **en ce que** la tête de mesure (5) est également munie de pointes mécaniques (18), venant prendre appui sur la zone inactive (11) desdits composants afin d'assurer leur maintien sur la platine.

2. Dispositif pour réaliser la caractérisation des performances électro-optiques d'un composant semi-conducteur selon la revendication 1, ***caractérisé* en ce que** les bossages de la platine (3) reçoivent une interface (4) réalisée en indium.

3. Dispositif pour réaliser la caractérisation des performances électro-optiques d'un composant semi-conducteur selon la revendication 2, ***caractérisé* en ce que** l'interface en indium (4) présente une épaisseur comprise entre 20 et 200 micromètres et est rapportée par collage sur les bossages ménagés au sein de la platine (3).

4. Dispositif pour réaliser la caractérisation des performances électro-optiques d'un composant semi-conducteur selon l'une des revendications 1 à 3, ***caractérisé* en ce que** les grilles coulissantes de positionnement (14, 15) sont munies au niveau des tranches de leurs parois latérales en regard, de micro-dentures (17) interdisant un déplacement intempestif dudit composant après mise en place.

5. Dispositif pour réaliser la caractérisation des performances électro-optiques d'un composant semi-conducteur selon l'une des revendications 1 à 4, ***caractérisé* en ce que** la tête de mesure (5) comporte également des pointes surnuméraires afin d'optimiser le maintien mécanique du composant sur la platine et/ou des pointes spécifiques du type plot à piston (20) de dimensions plus importantes et aptes à coopérer avec des zones spécifiques dédiées, ménagées au niveau de la zone inactive du composant.
